# EUROPEAN PATENT SPECIFICATION

(11) **EP 0 774 799 B1**
(45) Date of publication and mention of the grant of the patent: **24.11.1999**
(21) Application number: 96830484.0
(22) Date of filing: 27.09.1996
(51) Int. Cl.: H01R 9/07, H05K 1/00

(54) **Method for making flexible printed circuit boards, in particular for motor vehicles, and printed circuit board made thereby**
Verfahren zur Herstellung von flexiblen gedruckten Leiterplatten, insbesondere für Motorfahrzeuge, und dabei hergestellte gedruckte Leiterplatten
Procédé de production de plaquettes flexibles de circuits imprimés, en particulier pour des véhicules automobiles, et plaquettes de circuits imprimés réalisées ainsi

(30) Priority: 15.11.1995 IT MI952346
(43) Date of publication of application: 21.05.1997
(73) Proprietor: CAVIS S.r.l., I-15023 Felizzano (Alessandria) (IT)
(72) Inventor: Colombo, Paolo, c/o Cavis S.r.l., 15023 Felizzano, (Alessandria) (IT)
(74) Representative: Cicogna, Franco

(56) References cited:
- EP-A- 0 117 809
- WO-A-95/21474

## Description

### BACKGROUND OF THE INVENTION

The present invention relates to a method for making flexible printed circuit boards, in particular for motor vehicles, and printed circuit board made thereby.

As is known, the switching center of motor vehicles is specifically designed for collecting at a single region of the motor vehicle, the wiring of the several motor vehicle circuits, as well as to distribute the power supplies, and performing protection operations through fuses as well as control operations through relays.

A motor vehicle center of the above mentioned type is usually constituted by an inner electric circuit, made by different techniques (rigid printed circuit boards, flexible printed circuit boards, sheared copper circuits, and so on), and being provided with different types of electrical terminals for coupling the replaceable fuses, the relays, also of replaceable type, as well as the wiring assemblies.

One of the main drawbacks of this construction is that it is not possible to assemble thereon electronic components, since the electronic components can be exclusively assembled on rigid printed circuit boards.

Thus, the at present commercially available rigid printed circuit boards can not be used in central units as those usually adopted in the motor vehicle field, in which a finished circuit can frequently have a not planar configuration, in which said circuit must be suitable for comparatively high electric currents.

The document EP-A-117 809 discloses a method for making flexible printed circuit boards, and the boards obtained thereby, respectively, substantially according to the preambles of independent claims 1 and 8 of this application.

### SUMMARY OF THE INVENTION

Accordingly, the aim of the present invention is to solve the above mentioned problem, by providing a method for making flexible printed circuit boards which are specifically suitable for use in conventional central units used in the motor vehicle field, and which flexible boards are also suitable to support any types of electronic components.

Within the scope of the above mentioned aim, a main object of the present invention is to provide such a method which can use, as starting components, rigid printed circuit boards susceptible to be processed on automatic processing lines, so as to greatly reduce the making cost.

Another object of the present invention is to provide such a method which affords the possibility of making printed circuit boards susceptible to meet all of the assembling requirements related to the construction of switching center units for motor vehicles.

According to one aspect of the present invention, the above mentioned aim and objects, as well as yet other objects, which will become more apparent hereinafter, are achieved by a method for making flexible printed circuit boards, specifically designed for use in the motor vehicle field, according to claim 1.

### BRIEF DESCRIPTION OF THE DRAWINGS

The characteristics and advantages of the method according to the present invention will become more apparent hereinafter from the following detailed disclosure of a preferred, though not exclusive, embodiment thereof, which is illustrated, by way of a merely indicative, but not limitative, example in the accompanying drawings, where:
Figure 1 is a perspective view illustrating the starting rigid printed circuit boards for carrying out the making method according to the present invention;
Figure 2 illustrates those same rigid printed circuit boards shown in figure 1, and clearly showing the holes provided for receiving respective metal contacts;
Figure 3 is a perspective view illustrating one of the mentioned metal contacts;
Figure 4 illustrates the interconnection of two rigid printed circuit boards by a flexible printed circuit board;
Figure 5 illustrates the same interconnection shown in figure 4, in perspective;
Figure 6 is an enlarged cross-sectional view illustrating a detail of the interconnection between the flexible printed circuit board and one of the rigid printed circuit boards, said interconnection being performed by a metal contact of the type shown in figure 3;
   and

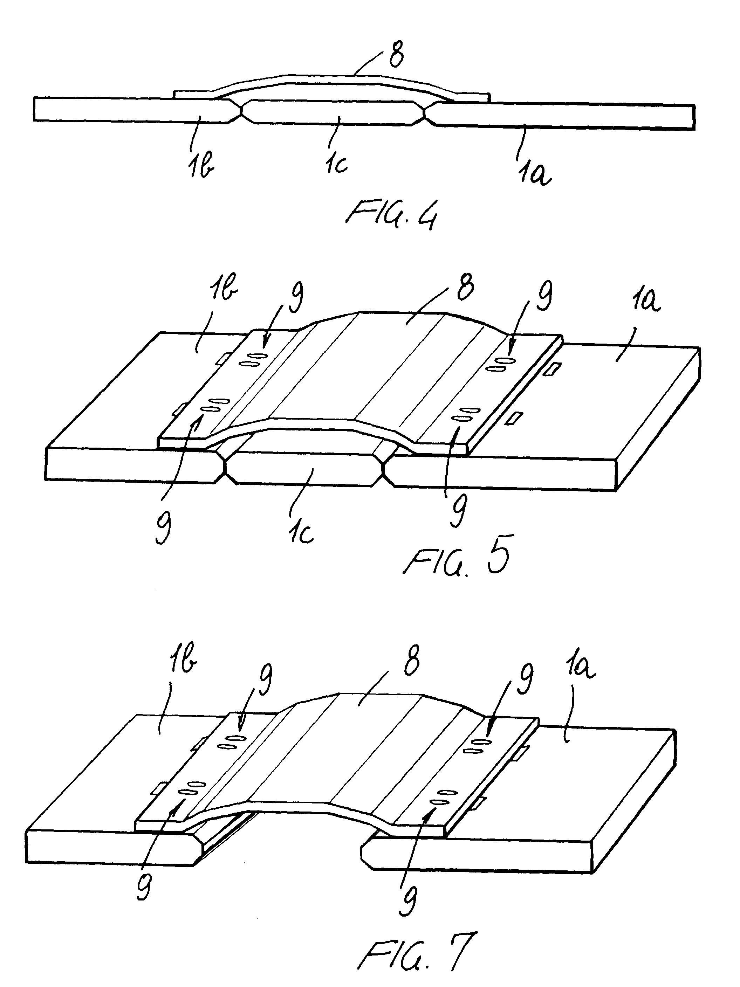

Figure 7 is a perspective view illustrating a flexible or foldable printed circuit board, made by the method according to the present invention, and comprising two rigid printed circuit boards interconnected to one another by a flexible printed circuit board.

### DESCRIPTION OF THE PREFERRED EMBODIMENT

With reference to the number references of the above mentioned figures, the method according to the present invention comprises the step of providing, in a single rigid printed circuit board 1, slots 2 or weakening grooves adapted to operate as corresponding breaking lines, in the assembling operation.

The above mentioned slots 2 can be formed by any suitable type of machine tool, for example a milling machine, before assembling the components on the rigid printed circuit board 1.

The milled slots 2, in particular, can be parallel to one another or they can extend with any desired patterns, depending on the bending configuration and shape to be provided on the finished printed circuit board, as it will become more apparent hereinafter.

In particular, the rigid printed circuit board 1 can be formed either with a single copper surface or face, or with two copper faces, or it can also be of a multilayered construction.

Moreover, the base laminate material constituting the rigid printed circuit board 1 substrate can be constituted by any suitable base laminate material such as, for example, glass reinforced resins FRa, FR3, CEM-1, or any other known types of materials.

As shown, the slots or grooves 2 subdivide the rigid printed circuit board 1 into two rigid printed circuit boards 1a and 1b which are connected to one another by a connecting portion lc provided to be removed.

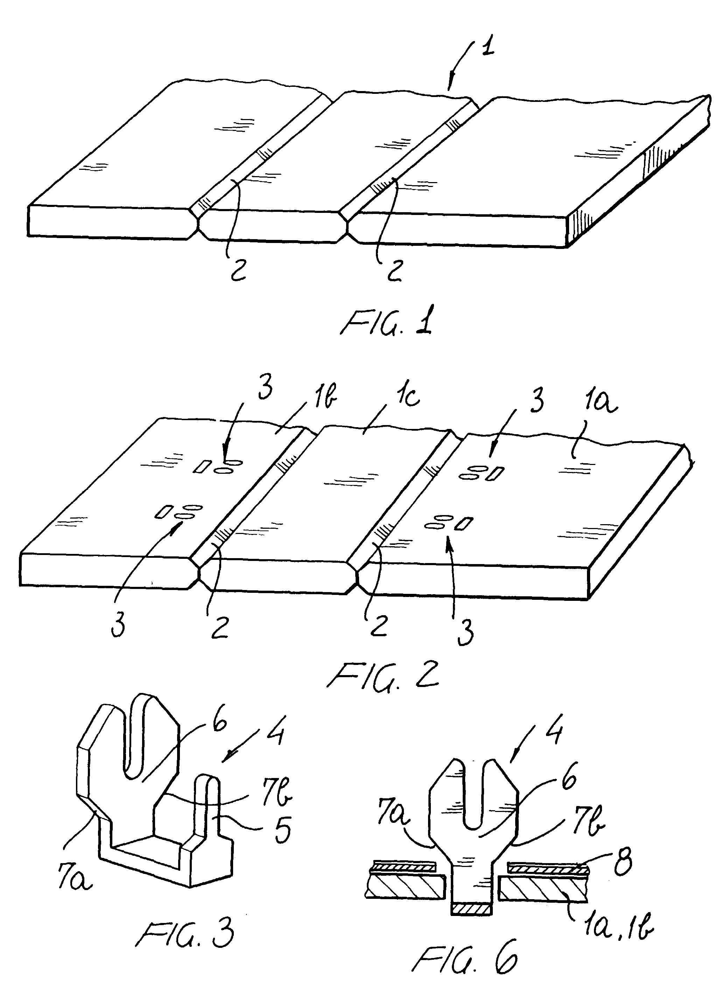

Near the slots or grooves 2 on the rigid printed circuit boards 1a and 1b are arranged hole 3 assemblies, provided for receiving corresponding metal contacts 4 of the type being shown in figure 3.

More specifically, each metal contact 4 has a substantially U-shaped configuration, one leg 5 of which having a substantially rectangular cross section and being provided for soldering to the rigid printed circuit board 1a or 1b.

The other leg or terminal 6 of the metal contacts 4 has a fork-like configuration, and is provided, laterally, with two bevels 7a and 7b operating for restraining a flexible printed circuit board 8 adapted to connect the two rigid printed circuit boards 1a and 1b.

In particular, the flexible printed circuit board 8 can comprise any suitable base laminate material, having mechanical and electric characteristics suitable for the intended application.

The supporting elements used for making the flexible printed circuit board 8 are preferably made of materials which are commercially available with the names of Mylar, Capton, etc.

These supporting elements will allow to use copper traces having a thickness up to 270 µm, which are suitable for comparatively high electric currents.

As shown, the flexible printed circuit board 8 is provided, along the edges thereof, with a plurality of holes 9 adapted to fixedly engage between the beveled portions 7a and 7b of the metal contacts 4 so as to allow to easily perform a tin soldering operation, of the wave technology type, in order to connect the flexible printed circuit board 8 to the metal contacts 4, thereby also connecting the flexible printed circuit board 8 to the rigid printed circuit board 1a or to the rigid printed circuit board 1b.

Upon ending the soldering operation, the flexible printed circuit board 8 will operate as an electrically and mechanically coupling element between the rigid printed circuit board 1a and the rigid printed circuit board 1b.

At this time, the portion 1c can be removed from the circuit boards 1a and 1b by performing a breaking operation at the slots 2.

From the above disclosure and the observation of the accompanying drawings, it should be apparent that the invention fully achieves the intended aim and objects.

In particular, the fact is to be pointed out that a method has been provided which allows to easily make flexible printed circuit boards, comprising rigid printed circuit boards on which can be easily assembled the electronic components and which can be easily used for making switching center units, in particular for motor vehicles.

It should be also apparent that the subject method has been disclosed and illustrated exclusively by way of a merely indicative and not limitative example, and exclusively in order to demonstrate the features of the invention and a preferred embodiment for practicing it.

Accordingly, the disclosed method is susceptible to several variations and modifications, within the skillness capability of one skilled in the art, without departing from the scope of the claims.

## Claims

1. A method for making flexible printed circuit boards, specifically designed for use in the motor vehicle field, said method comprises the step of interconnecting at least two rigid printed circuit boards (1a, 1b), by using at least a flexible printed circuit board (8) said rigid printed circuit boards and said flexible printed circuit board being provided with locally corresponding holes for mechanical and electrical connection by soldering, characterized in that said method comprises the step of providing a metal contact assembly including a plurality of metal contacts (4) to be engaged in said holes (3) formed in said rigid printed circuit boards (1a, 1b) and said flexible printed circuit board (8), said metal contacts (4) being connected in said holes (3) by soldering.

2. A method according to Claim 1, characterized in that said two rigid printed circuit boards (1a, 1b) are made from a single rigid printed circuit board (1) on which are formed a plurality of weakening grooves (2) for facilitating the breaking away of said single rigid printed circuit board (1).

3. A method according to Claims 1 and 2, characterized in that the breaking operation is performed after having interconnected the two rigid printed circuit boards (1a, 1b) by said flexible printed circuit board (8).

4. A method according to one or more of the preceding claims, characterized in that said flexible printed circuit board (8) is a single-face flexible printed circuit board.

5. A method according to one or more of the preceding claims, characterized in that said two rigid printed circuit boards (1a, 1b) and said flexible printed circuit board (8) are connected by a tin soldering operation, according to the wave connection technique, in which said metal contacts (4) are coupled to said flexible printed circuit board (8).

6. A method according to one or more of the preceding claims, characterized in that said metal contacts (4) have a substantially U-shaped configuration including a single terminal (5) to be soldered on the related rigid printed circuit board, and the other terminal (6) of which is provided with a beveled portion (7a, 7b) for restraining said flexible printed circuit board (8).

7. A method according to one or more of the preceding claims, characterized in that said other terminal (6) of said metal contacts (4) has a fork-like configuration.

8. A flexible printed circuit board, specifically designed for making a center unit for motor vehicles, said flexible printed circuit board comprising at least two rigid printed circuit boards (1a, 1b) interconnected to one another by at least a flexible printed circuit board (8) said rigid printed circuit boards and said flexible printed circuit board being provided with locally corresponding holes for mechanical and electrical connection by soldering, characterized by a metal contact assembly including a plurality of metal contact elements (4) engaged in said holes (3) formed in said rigid printed circuit boards (1a, 1b) and in said flexible printed circuit board (8) and being connected to said printed circuit boards (1a, 1b) by soldering.

9. A printed circuit board according to Claim 8, characterized in that said metal contact elements (4) have a substantially U-shape with a single terminal (5) and the other terminal (6) of fork-shape and being provided with a beveled portion (7a, 7b) engageable with said flexible printed circuit board (8).

## Patentansprüche

1. Verfahren zur Herstellung von flexiblen gedruckten Leiterplatten, insbesondere für die Verwendung bei Kraftfahrzeugen, wobei das Verfahren den Schritt einer Verbindung von wenigstens zwei starren gedruckten Leiterplatten (1a,1b) unter Verwendung wenigstens einer flexiblen gedruckten Leiterplatte (8) umfaßt, wobei die starren gedruckten Leiterplatten und die flexible gedruckte Leiterplatte mit lokal korrespondierenden Löchern für eine mechanische und elektrische Verbindung mittels Löten versehen sind,
**dadurch gekennzeichnet**, daß
das Verfahren den Schritt umfaßt, eine Metallkontaktbaugruppe zur Verfügung zu stellen, welche eine Vielzahl von Metallkontakten (4) aufweist, die mit den in den starren gedruckten Leiterplatten (1a,1b) und der flexiblen gedruckten Leiterplatte (8) ausgebildeten Löchern (3) in Eingriff gebracht werden, wobei die Metallkontakte (4) in den Löchern (3) mittels Löten verbunden werden.

2. Verfahren nach Anspruch 1,
**dadurch gekennzeichnet**, daß
die zwei starren gedruckten Leiterplatten (1a,1b) aus einer einzelnen, starren gedruckten Leiterplatte (1) hergestellt sind, auf der eine Vielzahl von Sollbruchnuten (2) ausgebildet sind, um das Auseinanderbrechen der einzelnen, starren gedruckten Leiterplatte (1) zu erleichtern.

3. Verfahren nach Anspruch 1 und 2,
**dadurch gekennzeichnet**, daß
der Vorgang des Auseinanderbrechens nach der gegenseitigen Verbindung der zwei starren gedruckten Leiterplatten (1a,1b) durch die flexible gedruckte Leiterplatte (8) ausgeführt wird.

4. Verfahren nach einem oder mehreren der vorstehenden Ansprüche,
**dadurch gekennzeichnet**, daß
die flexible gedruckte Leiterplatte (8) eine einseitig bedruckte flexible Leiterplatte ist.

5. Verfahren nach einem oder mehreren der vorstehenden Ansprüche,
**dadurch gekennzeichnet**, daß
die zwei starren gedruckten Leiterplatten (1a,1b) und die flexible gedruckte Leiterplatte (8) durch einen Zinnlötvorgang entsprechend der Wellenverbindungstechnik miteinander verbunden werden, wobei die Metallkontakte (4) an die flexible gedruckte Leiterplatte (8) gekoppelt sind.

6. Verfahren nach einem oder mehreren der vorstehenden Ansprüche,
**dadurch gekennzeichnet**, daß
die Metallkontakte (4) eine im wesentlichen U-förmige Konfiguration mit einem einzelnen Anschlußpol (5) aufweisen, der an die zugehörige, starre gedruckte Leiterplatte gelötet wird, wobei der andere Anschlußpol (6) mit einem angefasten Teil (7a, 7b) versehen ist, um die flexible gedruckte Leiterplatte (8) zurückzuhalten.

7. Verfahren nach einem oder mehreren der vorstehenden Ansprüche,
**dadurch gekennzeichnet**, daß
der andere Anschlußpol (6) der Metallkontakte (4) eine gabelähnliche Konfiguration aufweist.

8. Flexible gedruckte Leiterplatte, insbesondere für die Herstellung einer zentralen Einheit für Kraftfahrzeuge, wobei die flexible gedruckte Leiterplatte wenigstens zwei starre gedruckte Leiterplatten (1a,1b) aufweist, die miteinander durch wenigstens eine flexible gedruckte Leiterplatte (8) verbunden sind, wobei die starren gedruckten Leiterplatten und die flexible gedruckte Leiterplatte mit lokal korrespondierenden Löchern für eine mechanische und elektrische Verbindung mittels Löten versehen sind,
**gekennzeichnet** durch
eine Metallkontaktbaugruppe mit einer Vielzahl von Metallkontaktelementen (4), die mit den in den starren gedruckten Leiterplatten (1a,1b) und in der flexiblen gedruckten Leiterplatte (8) ausgebildeten Löchern (3) in Eingriff stehen, und durch Löten mit den gedruckten Leiterplatten (1a,1b) verbunden werden.

9. Gedruckte Leiterplatte nach Anspruch 8,
**dadurch gekennzeichnet**, daß
die Metallkontaktelemente (4) im wesentlichen eine U-Form mit einer einzelnen Anschlußpol (5) aufweisen, und der andere Anschlußpol (6) gabelförmig, und mit einem angefasten Teil (7a,7b), versehen ist, welcher mit der flexiblen gedruckten Leiterplatte (8) in Eingriff bringbar ist.

## Revendications

1. Procédé pour la fabrication de cartes circuits imprimés flexibles, spécifiquement conçus pour l'utilisation dans le domaine des véhicules à moteur, ledit procédé comprenant l'étape d'interconnexion d'au moins deux cartes de circuit imprimé rigides (1a, 1b), en utilisant au moins une carte de circuit imprimé flexible (8) lesdites cartes de circuit imprimé rigides et ladite carte de circuit imprimé flexible étant munies localement avec des trous correspondants pour une connexion mécanique et électrique par brasage **caractérisé en ce que** ledit procédé comprend l'étape de procurer un assemblage métallique de contact comprenant une pluralité de contacts de métal (4) qui peuvent être engagés dans lesdits trous (3) formés dans lesdites cartes rigides de circuit imprimé (1a, 1b), et ladite carte de circuit imprimé flexible (8), lesdits contacts de métal (4) étant connectés dans lesdits trous (3) par brasage.

2. Procédé selon la revendication 1, **caractérisé en ce que** lesdites deux cartes rigides de circuit imprimé (1a, 1b) sont fabriquées à partir d'une carte de circuit imprimé simple (1) sur laquelle sont formées une pluralité de rainures d'affaiblissement (2) pour faciliter la cassure de ladite carte de circuit imprimé rigide (1).

3. Procédé selon la revendication 1 et 2, **caractérisé en ce que** l'opération de cassure est réalisée après avoir interconnecté les deux cartes de circuit imprimé rigides (1a, 1b) avec ladite carte de circuit imprimé flexible (8).

4. Procédé selon l'une quelconque des revendications précédentes **caractérisé en ce que** ladite carte de circuit imprimé flexible est une carte de circuit imprimé sur une seule face, flexible (« single-face flexible printed circuit board »).

5. Procédé selon l'une quelconque des revendications précédentes, **caractérisé en ce que** lesdites deux cartes de circuit imprimé rigides (1a, 1b) et ladite carte de circuit imprimé flexible (8) sont connectées par une opération de brasage à l'étain, selon la technique de brasage tendre à la vague (« wave connection technique »), dans laquelle lesdits contacts de métal (4) sont couplés à ladite carte de circuit imprimé flexible (8).

6. Procédé selon l'une quelconque des revendications précédentes, **caractérisé en ce que** lesdits contacts de métal (4) présentent une configuration sensiblement en forme de U comprenant une extrémité terminale (5) pour être brasée sur la carte de circuit imprimé relative, et l'autre extrémité (6) qui est munie avec une partie biseautée (7a, 7b) pour le maintien de ladite carte de circuit imprimé (8).

7. Procédé selon l'une quelconque des revendications précédentes, **caractérisé en ce que** ladite poudre extrémité (6) desdits contacts en métal (4) présente une configuration de type fourchette.

8. Carte de circuit imprimé spécialement conçue pour la fabrication d'un groupe central pour véhicule à moteur, ladite carte de circuit imprimé comprenant au moins deux cartes de circuit imprimé rigides (1a, 1b) interconnectées entre elles par au moins une carte de circuit imprimé flexible, lesdites cartes de circuit imprimé rigides et ladite carte de circuit imprimé flexible étant munies localement avec des trous correspondants pour une connexion mécanique et électrique par brasage, **caractérisée** par un assemblage de contacts en métal comprenant une pluralité d'éléments de contacts en métal (4) engagés dans lesdits trous (3) formés dans lesdites cartes de circuit imprimé rigides (1a, 1b), et dans ladite carte de circuit imprimé flexible (8) et étant connectés auxdites cartes de circuit imprimé (1a, 1b) par brasage.

9. Carte de circuit imprimé selon la revendication 8, **caractérisée en ce que** lesdits éléments de contact en métal (4) présentent une forme sensiblement en U avec une extrémité simple (5) et l'autre extrémité (6) avec une forme de type fourchette et étant munie avec une partie biseautée (7a, 7b) engageable avec ladite carte flexible de circuit imprimé (8).
